Europäisches Patentamt

European Patent Office

Office européen des brevets

(11) Publication number: **0 185 544**
**B1**

(12) **EUROPEAN PATENT SPECIFICATION**

(45) Date of publication of patent specification: **28.02.90**

(21) Application number: **85309201.3**

(22) Date of filing: **17.12.85**

(51) Int. Cl.⁵: **H 01 L 27/10, G 11 C 11/40**

(54) IC memory devices.

(30) Priority: **18.12.84 US 683288**

(43) Date of publication of application:
**25.06.86 Bulletin 86/26**

(45) Publication of the grant of the patent:
**28.02.90 Bulletin 90/09**

(84) Designated Contracting States:
**AT BE CH DE FR GB IT LI LU NL SE**

(56) References cited:
**EP-A-0 037 930**
**US-A-4 314 359**

**PATENTS ABSTRACTS OF JAPAN, vol. 7, no. 45
(E-160) 1190r, 23rd February 1983; & JP - A - 57
196 563 (NIPPON DENKI K.K.) 02-12-1982**

(73) Proprietor: **ADVANCED MICRO DEVICES, INC.**
**901 Thompson Place P.O. Box 3453**
**Sunnyvale, CA 94088 (US)**

(72) Inventor: **Wanderman, Drew**
**468 Channing Drive**
**Palo Alto California (US)**
Inventor: **Weinberg, Matthew**
**111 North Rengsdorf, No. 6**
**Mountain View California (US)**

(74) Representative: **Sanders, Peter Colin**
**Christopher et al**
**BROOKES & MARTIN High Holborn House**
**52/54 High Holborn**
**London WC1V 6SE (GB)**

Courier Press, Leamington Spa, England.

**Description**

Memory cells in integrated circuits, consisting of cross-coupled transistors forming a flip-flop circuit, are subject to soft errors caused by parasitic charges generated by alpha particles striking the integrated circuit structure (alpha strike). Such alpha particles, which may come from the ceramics used in packaging the integrated circuit, generate electron-hole pairs in the incident path of the alpha particles due to their energy loss. These electron-hole pairs may generate a parasitic noise current which may result in turning on the off transistor in the flip-flop circuit of the memory cell to cause a soft error.

It is known that the problem of alpha strike can be reduced or eliminated by reducing the thickness and/or resistivity of the epitaxial silicon layer separating the buried collector layer from the base which effectively raises the collector-base capacitance. Increasing the collector-base capacitance increases the time constant of the memory cell and, therefore, the time required for the flip-flop circuit of the memory cell to invert from one stable state to the other is increased. This increases the immunisation of the circuit to parasitic charges generated by alpha particles which tend to be instantaneous.

However, this increased capacitance degrades performance of the integrated circuit structure or chip by slowing down the logic circuit portions due to the increased time constant resulting from the modification to the epitaxial layer.

Kato et al U.S. Patent 4,314,359 addressed this problem by selective heavy doping of an N+ buried collector layer in only the memory portion of an integrated circuit structure with ion-implanted arsenic. This provides auto-doping of a region over the buried layer to effectively reduce the collector-base spacing and thereby increase the collector-base capacitance in only the memory cell area. A further example is given in JP—A—57 196 563.

However, it is difficult to grow epitaxial silicon over ion-implanted silicon without generating defects in the silicon. Furthermore, out diffusion or autodoping is difficult to control to obtain a precise desired level of capacitance. If the region is under doped, i.e., the out diffusion is not sufficient, the capacitance increase will not be sufficient to obtain the desired increased time constant, and the cell will still be prone to soft errors from alpha particles. On the other hand, if the out diffusion is large some of the dopant may get into the active base region above, increasing the beta of the transistor.

It would, therefore, be desirable to provide an integrated circuit structure wherein the memory cell portion of the circuit was protected from alpha strike without degradation of the performance of the logic portion of the circuit in a manner, which is simple and easily controlled, and which does not cause silicon crystal defects.

It is therefore an object of the invention to provide an integrated circuit memory structure having enhanced protection against the effects of alpha particles striking the structure.

According to the present invention there is provided a method of constructing an improved bipolar as recited in claim 1.

In the accompanying drawings, by way of example only:

Figure 1 is a cross-sectional view of a portion of an integrated structure after formation of an N+ buried layer thereon, respectively, for formation of logic and memory transistors thereon.

Figure 2 is a cross-sectional view of the structure of Figure 1 showing selective removal, by etching of a portion of the N epitaxial silicon layer overlying the N+ buried layer in the memory region.

Figure 3 is a cross-sectional view of the structure of Figure 1 showing the preferred selective removal, by oxidation and oxide removal, of a portion of the N epitaxial silicon layer overlying the N+ buried layer in the memory region.

Figure 4A is a cross-section view of a portion of the structure of Figure 3 after construction of a logic transistor thereon.

Figure 4B is a cross-section view of a portion of the structure of Figure 3 after construction of a memory transistor thereon.

The illustrated structure provides enhanced immunity to the effects of alpha strike by selective increase of the collector-base capacitance in the memory transistors while retaining conventional collector-base capacitance in the logic transistor. Such an increase in capacitance in the memory portion of the structure only will not substantially affect the speed of the structure as would increased capacitance in the logic portion. Conversely, the effects of alpha strike, by changing the memory state of the memory cell, are much more severe in the memory portion of the structure than in the logic portion. Hence selective protection of the memory portion of the structure from the effects of alpha strike results in an improved bipolar memory cell structure without degradation of the performance of the structure.

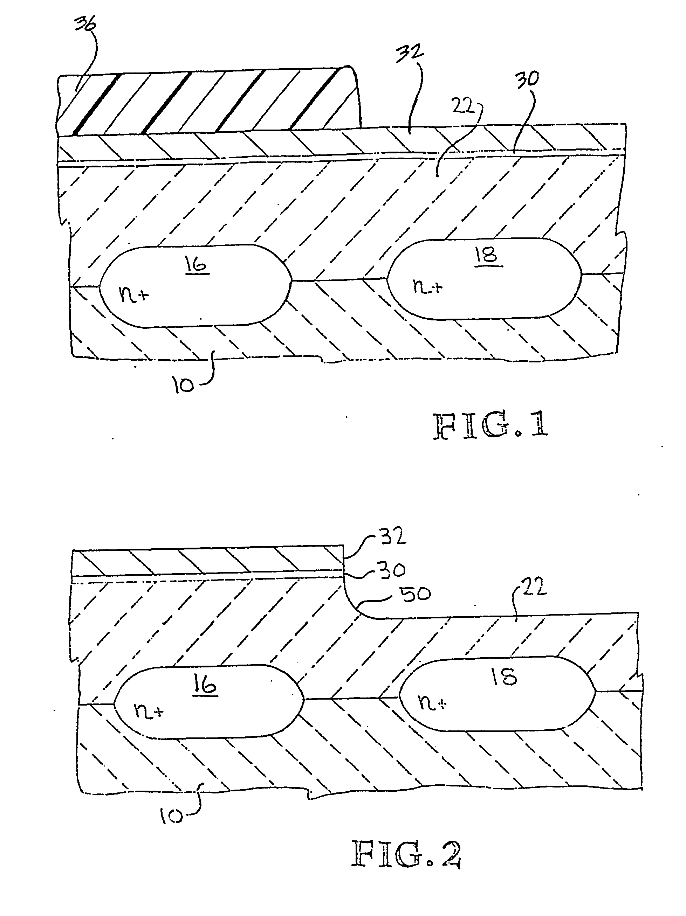

Referring now to Figure 1, an integrated structure is shown comprising a P-silicon substrate 10 on which is conventionally formed buried layer portions 16 and 18 which will respectively form the collectors of a logic transistor and a memory transistor. An N epitaxial layer 22 of silicon is then conventionally grown over buried layer portions 16 and 18.

At this point, a dielectric film is formed which preferably comprises growing a thin silicon oxide layer 30 and forming a silicon nitride layer 32 over oxide layer 30 using, for example, ammonia and silane as is well known to those skilled in the art.

The structure is then masked using photoresist 36 to provide an opening only in the memory area as

2

shown in Figure 1. The nitride and oxide layers are etched away through the mask opening using, for example, a plasma etch or a phosphoric acid wet etch.

After removal of the exposed nitride and oxide layers, and the photoresist layer, at least a portion of the epitaxial silicon layer 22 over buried layer portion 18 is removed. As previously stated, the purpose of the removal of at least some of the epitaxial silicon overlying the buried collector layer of the memory transistor is to reduce the depletion width between the collector region, and the base region which will be formed in the epitaxial silicon layer 22, sufficiently to provide the desired capacitance increase. Thus the epitaxial silicon removed is an amount which will leave remaining sufficient epitaxial silicon to permit the formation of a base region having a lower boundary ranging from just above the collector to partially diffused into the collector as will be discussed below. The buried layer to base spacing should not exceed 3 microns, and preferably, not exceed 2 microns.

The removal of at least some of the exposed epitaxial silicon in layer 22 overlying buried layer portion 18, representing the memory area of the structure, may be accomplished by etching the silicon through the mask. The resulting structure is illustrated in Figure 2. The epitaxial silicon may be removed with a wet etch, such as chromic trioxide.

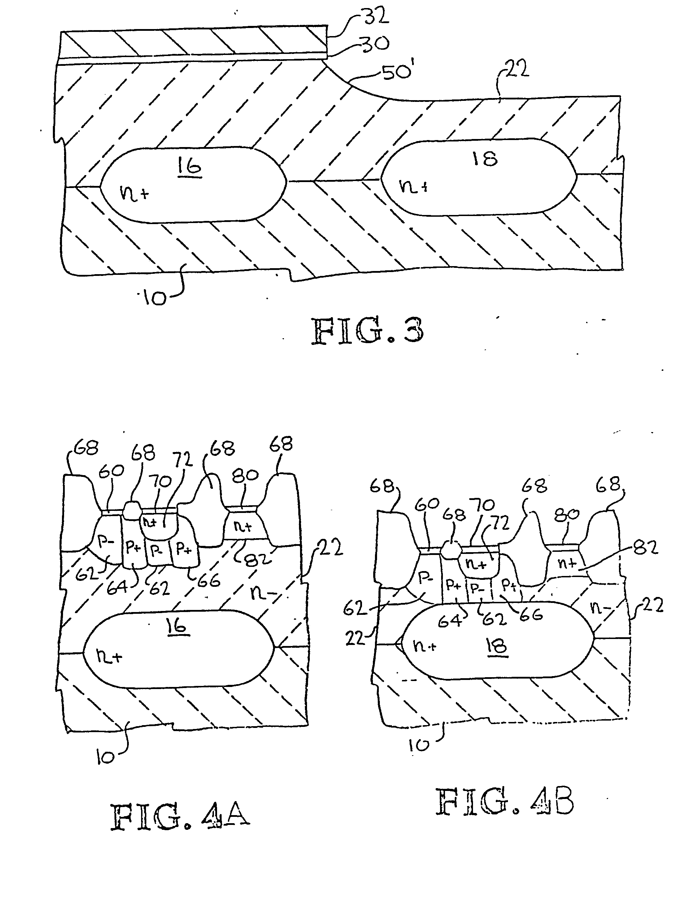

However as shown in Figure 3, the silicon is removed in a more precise and controlled manner by oxidizing the silicon and then selectively removing, with a conventional HF oxide etch, only the oxide grown through the mask. In this embodiment, a layer of silicon oxide is grown through the mask and then removed to provide the desired amount of silicon removal. The amount of silicon oxide grown will depend upon the amount of silicon layer 22 which one desires to remove, as previously discussed.

Comparison of the geometry of the remaining structure shown in Figure 2 at 50 after removal of the epitaxial silicon by etching with that shown in Figure 3 at 50' after removal of the epitaxial silicon via the oxidation method shows that a smoother step results from the preferred oxide growth and removal form of thinning epitaxial silicon layer 22 in the memory area.

As previously discussed, the actual amount of silicon in layer 22 which is removed in accordance with the practice of invention will vary depending upon the amount of increased capacitance needed to raise the time constant sufficiently to desensitize the memory circuit to instantaneous charges or noise generated from an alpha particle striking the structure. It has been found that removal of all but about 0.3 to 1.5 microns of epitaxial silicon layer 22 is usually adequate to provide the needed capacitance increase.

Figures 4A and 4B shows the structure of Figure 3 after construction, respectively, of a logic transistor and a memory transistor. Figure 4A shows the logic transistor, which is of conventional construction, and comprises a base contact 60 overlying a portion of intrinsic base region 62; an emitter contact 70 overlying an emitter region 72; and a collector contact 80 overlying collector region 82. P+ extrinsic base regions are provided at 64 and 66. Silicon oxide is shown at 68.

Figure 4B illustrates the memory transistor which, except for its location with respect to buried collector layer 18, may be constructed identically to the logic transistor of Figure 4A and, thus, is denoted with the same reference numerals.

However, advantageously, intrinsic base region 62 of the memory transistor in Figure 4B is not spaced as far from the N+ buried collector layer 18 as is the logic transistor base region 62 in Figure 4A from its buried collector layer 16. Thus, the collector-base capacitance between memory base 62 and memory collector 18 of the memory transistor in Figure 4B is increased over the conventional base-collector capacitance which is present in the logic transistor construction. This selective increase in capacitance thus renders the memory portion of the cell more immune from the effects of alpha strike without, however, interfering with the collector-base capacitance of the logic portion of the cell. Thus, the speed of the device is not affected by the modification.

It should be noted here, that while the memory transistor structure shown in Figure 4B illustrates intrinsic base region 62 as located immediately adjacent buried collector layer 18 with no epitaxial silicon 22 therebetween, it is within the purview of the invention that a thin layer of epitaxial silicon 22 may remain to separate intrinsic base 62 from buried collector 18 provided the layer 22 is thin enough to achieve the desired capacitance increase. It is also within the scope of the invention to permit some overlap, i.e., diffusion of the base region and the buried layer region into one another provided the diffusion overlap is not sufficient to result in an unacceptable increase in the beta of the memory transistor.

To further illustrate the invention, a number of sample parts were constructed and tested, each having 1K memory cells. A first group of 10 parts, denoted as Group A in the table below, were constructed in accordance with the invention with epitaxial silicon removed, in the memory cell areas only, by growing and then removing a 1.5 micron oxide layer over the buried memory collector layer. A second group of 10 parts, denoted as Group B, consisted of 10 parts constructed similarly to Group A except that the thickness of the oxide formed over the buried collector was only 1.0 microns. Group C represents 10 1K parts having a 1.5 micron layer of oxide grown and removed across the entire structure, i.e., in both the memory and logic transistor areas. Group D represents a fourth group of 10 parts constructed using conventional collector-base spacing with no removal fo epitaxial silicon between the intrinsic base and the buried collector layer.

Each of the parts in each group was tested on an accelerated basis for about 5—6 minutes using a thorium foil source of alpha particles with a given memory pattern written into each part. At the end of the test period, each cell was read to determine how many cells had changed from 1 to 0 (or 0 to 1) indicating a soft error due to alpha strike. The total elapsed testing time for all the parts in a group was then noted and a failure rate per hour calculated from the elapsed time and the total number of failures in all the parts tested for that group.

The speed of the logic was also measured and recorded as an average for each group to provide a comparison between the conventional prior art construction (Group D): the construction in accordance with the invention (Groups A and B); and the construction of Group C wherein the logic capacitance was also increased. With respect to speed, it will be seen that the structure of the invention is essentially the same as that of the conventional cell. On the other hand, the Group C structures, having increased logic capacitance as well as memory capacitance, were much slower.

With respect to soft error failures, Groups A and B, constructed in accordance with the invention, exhibit a radical improvement over the conventional prior art structures of Group D.

TABLE I

| GROUP | IEE 25°C (ma) | TIME 25°C (ns) | TIME 100°C (ns) | NUMBER OF FAILS | TIME (Minutes) | FAILURE RATE (Fails/Hr) |
|---|---|---|---|---|---|---|
| A | 120 | 8.7 | 8.8 | 1 | 54 | 1.11 |
| B | 123 | 8.9 | 8.9 | 3 | 60 | 3 |
| C | 105 | 11.2 | 12.7 | 0 | 48 | 0 |
| D | 139 | 7.6 | 9.3 | 258 | 54 | 287 |

## Claims

1. A method of constructing a bipolar memory cell device, the method comprising forming first (16) and second (18) buried collector layer portions on a silicon substrate (10), forming an epitaxial silicon layer (22) over the silicon substrate (10) and the buried collector layer portions (16, 18), and subsequently providing base (62) and emitter (72) regions for the respective buried collector portions (16, 18) to form bipolar logic transistors (Fig. 4B) and bipolar memory transistors (Fig. 4A) respectively, the method further comprising, prior to forming the base (62) and emitter (72) regions, at least a portion of the epitaxial silicon layer (22) separating the subsequently formed base region (62) from the second buried collector portions (18) associated with the memory transistors (Fig. 4B) is physicaly removed selective by etching whereby the collector-base capacitance of the memory transistors is increased without affecting the collector-base capacitance of the logic transistors.

2. A method according to claim 1 further characterised in that, prior to forming the base (62) and emitter (72) regions, the epitaxial silicon layer (22) is selectively masked to expose substantially only portions of the layer (22) over the second buried collector layer portions (18) associated with the memory transistors, and the said portion of the exposed epitaxial silicon layer (22) is then removed by etching.

3. The method of claim 1 or claim 2 wherein substantially all of the silicon (22) separating the region (62) of the memory transistors is removed.

4. The method of claim 1 or claim 2 wherein a sufficient amount of the silicon (22) is removed to provide a collector-base spacing of not greater than 3 µm in the memory transistors.

5. A method according to any one of the preceding claims wherein the silicon (22) is removed by first growing oxide of the silicon and then removing the oxide.

## Patentansprüche

1. Verfahren zur Herstellung einer Bipolar-Speicherzellenvorrichtung, wobei das Verfahren beinhaltet: die Bildung eines ersten (16) und eines zweiten (18) vergrabenen Kollektorschichtbereichs auf einem Siliziumsubstrat (10), die Bildung einer Epitaxie-Siliziumschicht (22) über dem Siliziumsubstrat (10) und den vergrabenen Kollektorschichtbereichen (16, 18), und das nachfolgende Vorsehen von Basis- (62) und Emitterbereichen (72) für die jeweiligen vergrabenen Kollektorbereiche (16, 18), um jeweils Bipolar- Logik-Transistoren (Fig. 4B) und Bipolar- Speichertransistoren (Fig. 4A) zu bilden, wobei das Verfahren vor der Bildung des Basis- (62) und des Emitterbereichs (72) ferner das physikalische Entfernen wenigstens eines Bereichs der Epitaxie-Siliziumschicht (22), der den nachfolgend gebildeten Basisbereich (62) von den zweiten, den Speichertransistoren (Fig. 4B) zugeordneten vergrabenen Kollektorbereichen (18) trennt durch selektives Ätzen umfaßt, wodurch die Kollektor-Basis-Kapazität der Speichertransistoren ohne Beeinträchtigung der Kollektor-Basis-Kapazität der Logik-Transistoren erhöht wird.

2. Verfahren nach Anspruch 1, ferner dadurch gekennzeichnet, daß vor der Bildung des Basis- (62) und des Emitterbereichs (72) die Epitaxie-Siliziumschicht (22) selektiv maskiert wird, um im wesentlichen nur Teile der Schicht über den den Speichertransistoren zugeordneten zweiten vergrabenen Kollektorschichtbereichen (18) freizulegen, und daß der genannte Bereich der freigelegten Epitaxie-Siliziumschicht (22) dann durch Ätzen entfernt wird.

3. Verfahren nach Anspruch 1 oder Anspruch 2, bei dem im wesentlichen sämtliches Silizium (22), das den Bereich (62) der Speichertransistoren trennt, entfernt wird.

4. Verfahren nach Anspruch 1 oder Anspruch 2, bei dem eine ausreichende Menge des Siliziums (22) entfernt wird, um in den Speichertransistoren einen Kollektor-Basis-Abstand von nicht mehr als 3 µm zu bilden.

5. Verfahren nach einem der vorhergehenden Ansprüche, bei dem das Silizium (22) entfernt wird, indem zunächst Siliziumoxid aufgewachst und das Oxid sodann entfernt wird.

**Revendications**

1. Un procédé de fabrication d'un dispositif de cellules de mémoire bipolaires, qui consiste à former une première (16) et une seconde (18) parties de couche de collecteur enterrée sur un substrat (10) en silicium, à former une couche épitaxiale (22) en silicium au-dessus du substrat en silicium (10) et des parties (16, 18) de couche de collecteur enterrée, puis subséquemment à former des régions de base (62) et d'émetteur (72) pour les parties (16, 18) respectives de collecteur enterrées, pour former respectivement des transistors logiques bipolaires (Figure 4B) et des transistors de mémoire bipolaires (Figure 4A), le procédé consistant en outre, avant de former les régions de base (62) et d'émetteur (72), à enlever physiquement par gravure sélective, au moins une partie de la couche épitaxiale (22) de silicium qui sépare la région de base (62) formée subséquemment, des secondes parties de collecteur enterrées (18) associées aux transistors de mémoire (Figure 4B), augmentant ainsi la capacitance collecteur-base des transistors de mémoire, sans affecter la capacitance collecteur-base des transistors logiques.

2. Un procédé selon la revendication 1 qui consiste en outre, avant de former les régions de base (62) et d'émetteur (72), à masquer de façon sélective la couche de silicium épitaxiale (22) afin de n'exposer sensiblement que les parties de la couche (22) au-dessus des secondes parties (18) de couche de collecteur enterrée associées aux transistors de mémoire, puis à enlever par gravure ladite partie de couche de silicium épitaxiale (22) exposée.

3. Le procédé selon la revendication 1 ou la revendication 2, qui consiste à enlever sensiblement tout le silicium (22) séparant la région (62) des transistors de mémoire.

4. Le procédé selon la revendication 1 ou la revendication 2, qui consiste à enlever une quantité suffisante de silicium (22) pour obtenir un écartement collecteur-base qui n'est pas supérieur à 3 µm dans les transistors de mémoire.

5. Un procédé selon l'une quelconque des revendications précédentes qui consiste à enlever le silicium (22) d'abord par oxydation du silicium puis par enlèvement de l'oxyde.

FIG.1

FIG.2

FIG.3

FIG.4A

FIG.4B